# FASCICULE DE BREVET EUROPEEN

(11) **EP 0 924 844 B1**
(45) Date de publication et mention de la délivrance du brevet: **06.07.2011**
(21) Numéro de dépôt: 98403162.5
(22) Date de dépôt: 15.12.1998
(51) Int. Cl.: H02M 3/158, H03K 17/0814, H03K 17/10

(54) **Interrupteur haute tension réalisé à partir de cellules quasi-résonantes connectées en série**
Aus einer Reihenschaltung von quasiresonanten Zellen aufgebauter Hochspannungsschalter
High voltage switch based on quasi-resonant cells connected in series

(30) Priorité: 18.12.1997 FR 9716069
(43) Date de publication de la demande: 23.06.1999
(73) Titulaire: Commissariat à l'Énergie Atomique et aux Énergies Alternatives, 75015 Paris (FR)
(72) Inventeur: Chatroux, Daniel, 26200 Montelimar (FR); Lapassat, Nicolas, 26790 Suze-la-Rousse (FR); Rieux, Olivier, 38100 Grenoble (FR)
(74) Mandataire: Poulin, Gérard

(56) Documents cités:
- EP-A- 0 353 406
- YU-MING CHANG ET AL: "DESIGN AND ANALYSIS OF H-SOFT-SWITCHED CONVERTERS" IEE PROCEEDINGS: ELECTRIC POWER APPLICATIONS, vol. 142, no. 4, 1 juillet 1995, pages 255-261, XP000544143

## Description

### Domaine de l'invention

L'invention concerne un interrupteur électronique haute tension réalisé à partir d'une pluralité de cellules quasi-résonantes, connectées en série. Cet interrupteur haute tension est destiné à être utilisé, en particulier, dans des convertisseurs DC/DC haute tension (DC : courant continu).

### Etat de la technique

Les convertisseurs DC/DC haute tension sont des systèmes alimentés par une tension continue et qui permettent de délivrer, en sortie, une haute tension continue, c'est-à-dire une tension supérieure à 1 kV. Ils peuvent être utilisés, par exemple, au sein d'une alimentation continue haute tension, c'est-à-dire dans un système destiné à transformer l'énergie électrique issue du réseau électrique national en une haute tension continue.

Les alimentations continues haute tension comportent, généralement un étage élévateur de tension. Cet étage élévateur de tension transforme la tension alternative du réseau électrique national en une autre tension alternative de même fréquence, mais d'amplitude supérieure. Une régulation de la haute tension doit donc être opérée, soit en amont, soit en aval, de l'étage élévateur.

On distingue deux types d'alimentations haute tension:
- les alimentations haute tension régulées sur la basse tension, c'est-à-dire les alimentations dans lesquelles la régulation de la haute tension s'opère en amont de l'étage élévateur; et
- les alimentations haute tension régulées sur la haute tension, c'est-à-dire les alimentations dont la régulation de la haute tension s'opèrent en aval de l'étage élévateur.

Parmi les alimentations haute tension, certaines fonctionnent à la fréquence du réseau, soit 50 Hz en France. Ces alimentations comportent, par exemple, deux convertisseurs haute tension, qui utilisent la fréquence du réseau électrique. Ces deux convertisseurs, sont décrits dans les articles « The réalisation of the power converters for the CERN FR system of LEP », A. DELIZEE, J.-C. CARLIER, P. PROUDLOCK, IEEE Proceedings, 1990 Nineteenth Power Modulator Symposium et « Thigh voltage d. c. power supplies », J. S. BEKINK, A. J. J. COLIJN, Holec Projects, EPE Journal, June 1994. Les convertisseurs décrits dans ces articles comportent des transformateurs magnétiques qui permettent d'élever la tension alternative à la fréquence du réseau ; ils comportent également un redresseur, ainsi qu'un système de régulation à thyristors. La version, ainsi régulée, est introduite dans un étage élévateur, puis dans un étage de redressement et un filtrage ; on obtient ainsi, en sortie du convertisseur, une haute tension continue. Ces convertisseurs sont généralement utilisés pour de très fortes puissances et permettent la réalisation d'une alimentation avoisinant les 1 MW.

D'autres types d'alimentations haute tension fonctionnent en haute fréquence, c'est-à-dire à une fréquence d'au moins 10 kHz. Pour obtenir cette haute fréquence, le courant provenant du réseau électrique est d'abord redressé et filtré, permettant ainsi d'obtenir une basse tension continue. Il est ensuite introduit dans un étage onduleur qui consiste à transformer la basse tension continue en une tension alternative, grâce à l'onduleur. Cette tension est ensuite introduit dans l'étage élévateur, puis dans un autre étage de redressement et de filtrage avant de devenir une haute tension continue.

La régulation de la tension, dans ce type d'alimentation, peut avoir lieu à différents niveaux. Tout d'abord, elle peut avoir lieu sur le redressement de la tension issue du réseau, au moyen d'un pont de GRAETZ, comme cela est décrit dans l'article « L'électronique de puissance dans l'imagerie médicale », J. LAEUFFER et J. SALESSES, Revue Général de l'Electricité, Juin 1992.

Elle peut aussi être effectuée au niveau de la tension continue issue de l'étage de redressement et de filtrage. Elle est alors réalisée au moyen d'un hacheur, comme cela est décrit dans l'article « High power high voltage generator », I. BONANNI, L. CRISTOFOLI, Proceedings of EPE 87 Grenoble.

Dans ces deux cas, il s'agit d'une régulation de la tension continue fournie en entrée de l'étage onduleur. Cette solution est généralement utilisée lorsque l'onduleur utilisé est de type pleine onde et qu'il ne contrôle pas l'amplitude de sa tension alternative de sortie.

Toutefois, dans certains cas, en plus de la fréquence, l'amplitude de la tension alternative fournie en entrée de l'étage élévateur est réglée au niveau de l'étage onduleur. Cette opération est réalisée au moyen, par exemple, d'un onduleur résonant, tel que décrit dans le document « L'électronique de puissance dans l'imagerie médicale », J. LAEUFFER et J. SALESSES, Revue Générale de l'Electricité, Juin 1992 ou dans l'article « Les composants à grille isolée en mode thyristor-dual », H. FOCH, M. METZ, J. P. ARCHES, C. SAUBION, Revue Générale de l'Electricité, Février 1994 ou encore dans l'ouvrage intitulé « La commutation douce dans la conversion statique de l'énergie électrique », Y. CHERON, 1989, éditions Lavoisier.

Le transformateur est généralement un transformateur magnétique ; il peut être associé, à sa sortie, à un multiplicateur capacitif, ou à un double multiplicateur capacitif.

Une autre alimentation haute tension, décrite dans l'article « A TWT power supply for high phase stability transmitter », Sandro SANDRI, IEEE Proceedings, 1988 Eighteenth Power Modulator Symposium, Hilton Head, utilise le transformateur d'un flyback (hacheur inverseur isolé) pour réaliser la fonction élévation de tension. Dans cette alimentation, la tension issue du réseau électrique est redressée et filtrée de façon à obtenir une tension continue fixe, fournie en entrée du flyback. Celui-ci utilise alors une inductance couplée, appelée « transformateur du flyback », dont le rapport du nombre de spires fournit une élévation de tension. Les différents secondaires de cette inductance couplée sont mis en série afin d'additionner leurs tensions; la régulation s'opère, comme pour un flyback classique, sur le rapport cyclique de l'interrupteur. La tension de sortie d'une telle alimentation est de 25 kV pour une puissance de 400 W.

D'autres sortes d'alimentations sont régulées sur la haute tension. La régulation se fait alors, après l'étage élévateur de tension et l'étage de redressement et de filtrage.

En fait, la régulation est effectuée sur la haute tension dans le cas où l'on souhaite obtenir une très faible ondulation de la tension de sortie et une régulation rapide. Il faut noter que dans de nombreux cas, une prérégulation est possible sur la basse tension de l'alimentation. C'est le cas, notamment, lorsque la régulation haute tension est réalisée au moyen des régulateurs linéaires. Dans le cas d'une prérégulation, on peut utiliser les différents types d'alimentations présentées précédemment, c'est-à-dire les alimentations régulées sur la basse tension.

D'une façon générale, la régulation sur la haute tension nécessite des composants haute tension et souvent une haute puissance. Pour la réalisation d'une alimentation régulée sur la haute tension, on peut utiliser un régulateur linéaire sur la haute tension. Celui-ci est souvent réalisé au moyen de tétrodes, c'est-à-dire de tubes à vides permettant une régulation précise, comme cela est décrit dans « Analysis and control of a 130 kV pulsed tetrode regulator », C. R. ROSE, J. C. CRON, Seventh IEEE Pulsed Power Conference, Monterey, 1989 et dans « A 1 MW (CW) modulator-regulator system for gyroklystrons », Raymond C. BLACK, John KLOUZEK, IEEE Proceedings, 1984 Sixteenth Power Modulator Symposium.

D'une façon générale, les régulateurs linéaires, de par leur principe de fonctionnement, ont des rendements généralement médiocres. Par ailleurs, les régulateurs linéaires, utilisés en haute tension, à savoir les tétrodes, ont une durée de vie relativement limitée. Ils présentent, de plus, un coût élevé.

La régulation sur la haute tension peut également être réalisée au moyen d'une alimentation à découpage de type hacheur à modulation de largeur d'impulsion. Par rapport au régulateur linéaire, les alimentations à découpage ont l'avantage de présenter une bonne fiabilité et un rendement plus élevé. Par contre, ces alimentations nécessitent un (ou plusieurs) interrupteur(s) haute tension rapide(s). Les articles « La mise en série des transistors de puissance, présentation d'un hacheur 200 kW - 4 kV », de J. M. ANDREJAK, J. P. ARCHES et P. C. CABALEIRO, Electronique de puissance n° 10 et « High voltage converters promising technological developments », J. M. ANDREJAK, M. LESCURE, Proceedings of EPE 87 Grenoble, présentent un hacheur réalisé au moyen d'une mise en série de transistors bipolaires de puissance. Ce hacheur fonctionne à 4 kV en sortie pour une puissance de 200 kW. Cependant, un tel hacheur est difficile à mettre en oeuvre pour une haute tension.

Les systèmes de régulation sous basse tension sont amenés, pour traiter de fortes puissances, à gérer des courants importants, ce qui implique généralement de réaliser un interrupteur fort courant par une mise en parallèle de semiconducteurs, si la capacité en courant des différents semiconducteurs est insuffisante. Il se pose alors un problème au niveau de la fiabilité de ce dispositif car la destruction de l'un des composants en parallèle implique la mise en court-circuit de l'ensemble des semiconducteurs et donc la défaillance de l'alimentation.

Un autre problème est celui de la valeur du filtre capacitif de sortie. En effet, en cas de défaut sur un équipement alimenté en haute tension, par exemple en cas de court-circuit, l'énergie contenue dans le filtre de sortie se dissipe dans l'équipement, qui peut alors être endommagé ; la dégradation est d'autant plus importante que l'énergie stockée est grande. Aussi, il est nécessaire de limiter l'énergie contenue dans le filtre en diminuant la valeur de la capacité de filtrage. Par contre, l'efficacité du filtre, c'est-à-dire sa capacité à atténuer les ondulations de tension, augmente avec la valeur du condensateur de filtrage et avec la fréquence de découpage du système de régulation, sauf, bien sûr, dans le cas du régulateur linéaire. Ainsi, pour diminuer la valeur d'un filtre, tout en conservant son efficacité, il est nécessaire de réaliser un système de régulation à fréquence de découpage élevée. Toutefois, pour des fréquences supérieures à 10 kHz, ce problème est nettement réduit.

La réalisation d'une alimentation à découpage fonctionnant à une fréquence supérieure à 10 kHz et sous haute tension a donc été envisagée. Cette alimentation à découpage consiste, en fait, en un convertisseur DC/DC (c'est-à-dire un hacheur) alimenté sous haute tension et comportant un interrupteur K.

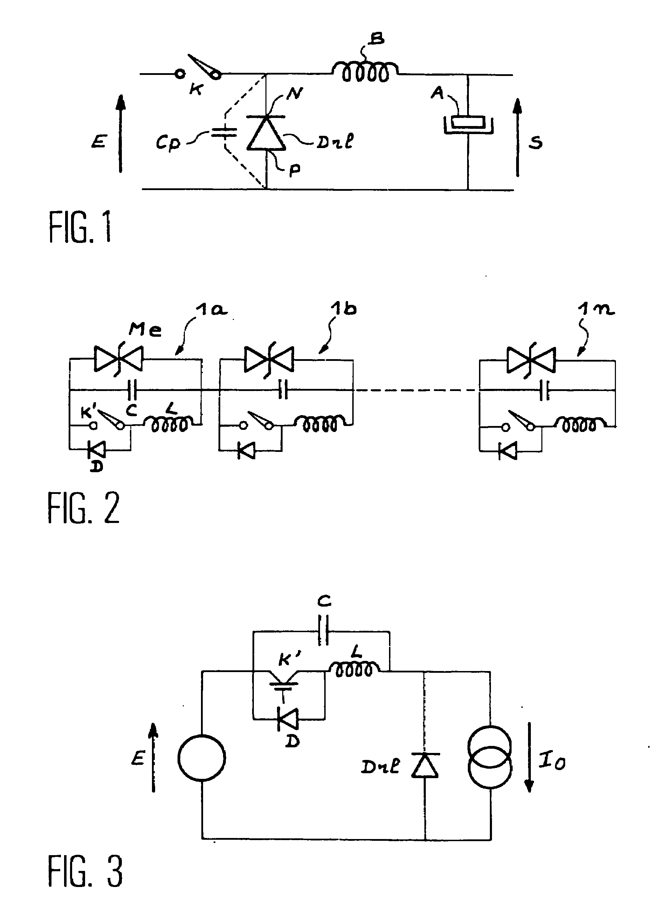

Sur la figure 1, on a représenté un tel convertisseur DC/DC. Il s'agit d'un hacheur-abaisseur. Ce convertisseur comporte une diode de roue libre Dᵣ₁ connectée par sa borne N à une inductance B et par sa borne P à une capacité A, elle-même connectée à l'inductance B. Un interrupteur K est connecté entre la borne N de la diode Dᵣ₁ et l'inductance B. La capacité Cₚ représente les capacités parasites du montage.

Ce convertisseur DC/DC est alimenté par une tension continue d'entrée E et délivre une tension continue de sortie S, qui est inférieure à la tension E. L'interrupteur K est réalisé, comme expliqué précédemment, par une pluralité de semiconducteurs connectés en série. Cependant, une telle structure fonctionne en commutation dure, c'est-à-dire que les commutations de l'interrupteur K s'opèrent avec une présence simultanée de courant et de tension, ce qui provoque des pertes de commutation.

Un tel convertisseur DC/DC à haute tension pose un problème du point de vue des capacités parasites du macro-interrupteur K avec l'environnement. En effet, dans l'exemple de la figure 1, au moment de l'amorçage de l'interrupteur K, les capacités parasites Cₚ se chargent, ce qui provoque un fort courant impulsionnel. Autrement dit, lorsque les semiconducteurs se ferment, la diode de roue libre se bloque et les capacités parasites Cₚ se chargent, provoquant des courants parasites élevés. Ces derniers provoquent à leur tour une dissipation importante au niveau des semiconducteurs. L'énergie contenue dans ces capacités parasites peut être importante si la tension est très élevée, ce qui peut amener la détérioration des semiconducteurs.

Il est connu du document « Design and analysis of H-soft-switched converters » (IEE Proceedings: Electric Power Applications, vol. 142, n°4, 1er juillet 1995, pages 255-261, XP 000544143) un interrupteur électronique comportant une cellule quasi-résonante. Il est également connu de la demande de brevet EP 0 353 406 A un commutateur haute tension dans lequel des interrupteurs sont connectés en série.

### Exposé de l'invention

L'invention a justement pour but de remédier aux inconvénients du convertisseur DC/DC haute tension, décrit précédemment. A cette fin, elle propose un interrupteur électronique haute tension pouvant être utilisé dans un convertisseur DC/DC haute tension, tel que celui décrit précédemment. Cet interrupteur prend alors la place de l'interrupteur K, décrit précédemment. L'interrupteur électronique haute tension de l'invention est réalisé au moyen d'une pluralité de cellules de commutation quasi-résonantes, connectées en série.

De façon plus précise, l'invention concerne un interrupteur électronique haute tension, traversé par un courant principal et comportant au moins deux cellules quasi-résonantes, connectées en série. Chacune de ces cellules comprend :
- au moins un condensateur de résonance ;
- au moins un moyen écrêteur ;
- au moins une inductance ;
- au moins une diode ; et
- au moins un moyen d'interruption connecté de façon antiparallèle sur la diode et assurant une interruption bidirectionnelle du courant et unidirectionnelle de la tension dans la cellule, ce moyen d'interruption étant tel que :
   - sa fermeture provoque une décharge du condensateur de résonance dans l'inductance, de sorte que le courant principal traverse chaque cellule ;
   - le courant de l'inductance s'inverse, provoquant la mise en conduction de la diode ; et
   - son ouverture se fait naturellement lors de l'annulation du courant traversant l'inductance et la diode.

Avantageusement, l'inductance, dans chaque cellule de quasi-résonance, est connectée en série avec Le moyen d'interruption, lui-même associé de façon anti-parallèle à la diode, cet ensemble inductance-diode-moyen d'interruption étant connecté en parallèle avec le condensateur de quasi-résonance, lui-même en parallèle avec le moyen écrêteur.

Selon un mode de réalisation de l'invention, l'inductance de chaque cellule est couplée magnétiquement avec les inductances des autres cellules.

L'invention concerne, en outre, un convertisseur DC/DC haute tension comportant une diode de roue libre, une inductance, au moins une capacité et un interrupteur haute tension, tel que décrit ci-dessus.

### Brève description des figures

- La figure 1, déjà décrite, représente un convertisseur DC/DC classique ;
- la figure 2 représente schématiquement l'interrupteur électronique haute tension conforme à l'invention et destiné à être utilisé dans le convertisseur DC/DC de la figure 1;

- la figure 3 représente schématiquement une cellule quasi-résonante de l'interrupteur de la figure 2 dans une structure de hacheur ; et
- les figures 4A à 4E représentent schématiquement les différentes phases de fonctionnement de la cellule quasi-résonante de la figure 3.

### Description de modes de réalisation de l'invention

L'invention concerne donc un interrupteur électronique haute fréquence destiné à être introduit, en particulier, dans un convertisseur DC/DC haute tension, tel que celui décrit précédemment.

Sur la figure 2, on a représenté schématiquement l'interrupteur de l'invention, réalisé à partir d'une pluralité de cellules quasi-résonantes connectées en série. Ces cellules sont référencées 1a, 1b, ..., 1n.

Comme on le voit sur cette figure 2, toutes les cellules sont identiques; aussi, seule la cellule 1a va être décrite en détail.

La cellule de commutation quasi-résonante la comporte une inductance L, connectée en série avec un moyen d'interruption K', appelé aussi interrupteur. Cet interrupteur K' est lui-même connecté de façon antiparallèle avec une diode D. Autrement dit, cette diode D est connectée par sa borne P à une borne placée entre l'interrupteur K' et l'inductance L.

L'interrupteur K', ainsi associé à sa diode D antiparallèle, est bidirectionnel en courant et unidirectionnel en tension.

Sur cet ensemble interrupteur-diode-inductance, est connecté, en parallèle, un condensateur de résonance C, lui-même connecté en parallèle sur un moyen écrêteur Mₑ.

Ce moyen écrêteur Mₑ, situé aux bornes du condensateur de résonance C, a pour rôle de limiter la tension maximale aux bornes de ce condensateur et de protéger en tension l'interrupteur K' et la diode D.

Ce moyen écrêteur est soit bidirectionnel en tension ou constitué de la mise en série d'une diode et d'un écrêteur monodirectionnel en tension pour permettre à la tension aux bornes du condensateur de changer de signe.

Le fonctionnement de l'interrupteur haute tension décrit ci-dessus est le suivant : la fermeture de l'interrupteur K' provoque une décharge résonante dans le condensateur de résonance C qui cède son énergie à l'inductance de résonance L. Le courant principal de l'interrupteur électronique haute tension traverse alors l'interrupteur K' de chaque cellule quasi-résonante 1a à 1n et des inductances de résonance L de chacune de ces cellules. L'ouverture du moyen d'interruption K' se fait de façon naturelle par annulation du courant dans l'inductance de résonance L, suite au blocage de la diode antiparallèle D.

Sur la figure 3, on a représenté la cellule quasi-résonante la au sein d'une structure de hacheur-abaisseur, telle que celle montrée sur la figure 1. Cette figure 3 et les suivantes sont destinées à expliquer le fonctionnement de l'interrupteur K' dans un convertisseur DC/DC haute tension. Pour cela, on supposera, par la suite, que le courant de sortie I₀ (représenté sur la figure par une source de courant) est constant et que la tension d'entrée dans le hacheur-abaisseur est constante et égale à E.

Sur cette figure 3, on a représenté, outre la tension d'entrée E et le courant de sortie I₀, la cellule 1a ainsi qu'une diode de roue libre Dᵣ₁ connectée par sa borne N à la cellule 1a et par sa borne P à l'entrée du hacheur-abaisseur. La source de courant I₀ est placée en parallèle sur cette diode de roue libre.

Sur cette figure 3, on n'a pas représenté le moyen écrêteur Mₑ de la cellule 1a, car il n'a pas véritablement de rôle dans le fonctionnement de la cellule; il permet simplement de limiter la tension aux bornes du condensateur C et de protéger, en tension, l'interrupteur K' et la diode D.

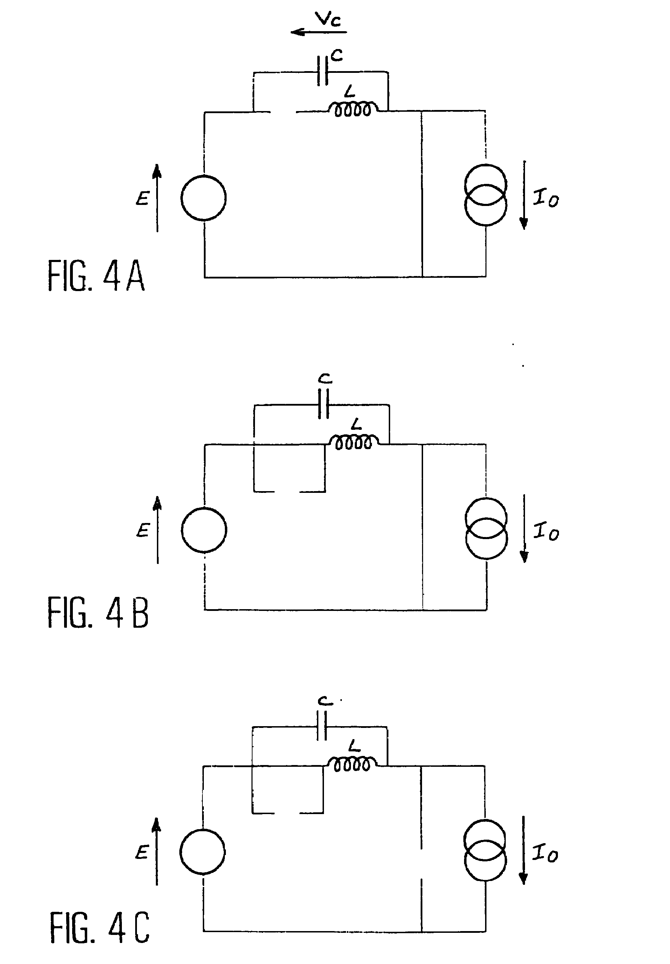

Sur les figures 4A à 4E, on a représenté schématiquement la cellule 1a dans la structure de hacheur-abaisseur de la figure 3, pendant ses différentes phases de fonctionnement.

La figure 4A représente la phase initiale du fonctionnement, à savoir la phase de roue libre, dans laquelle l'interrupteur K' et la diode D sont bloqués, tandis que la diode de roue libre Dᵣ₁ conduit. Il s'agit d'une phase stable. La tension V_{c} aux bornes du condensateur C est égale à la tension d'entrée E.

Sur la figure 4B, on a représenté la deuxième phase du fonctionnement de l'interrupteur. Dans cette phase, on ferme l'interrupteur K'. L'inductance L est alors soumise à la tension d'entrée E. La capacité C reste chargée à la tension E. Le courant dans la diode de roue libre Dᵣ₁ s'annule au bout d'un temps t égal à L x Iₒ/E, ce qui provoque l'ouverture de la diode de roue libre Dᵣ₁.

Sur la figure 4C, on a représenté la troisième phase de fonctionnement de l'interrupteur haute tension de l'invention. Dans cette phase, lorsque la diode de roue libre Dᵣ₁ se bloque, l'inductance L et la capacité C entrent en résonance.

Quand le courant dans l'inductance de résonance L s'annule et tend à devenir négatif, alors la diode D entre en conduction.

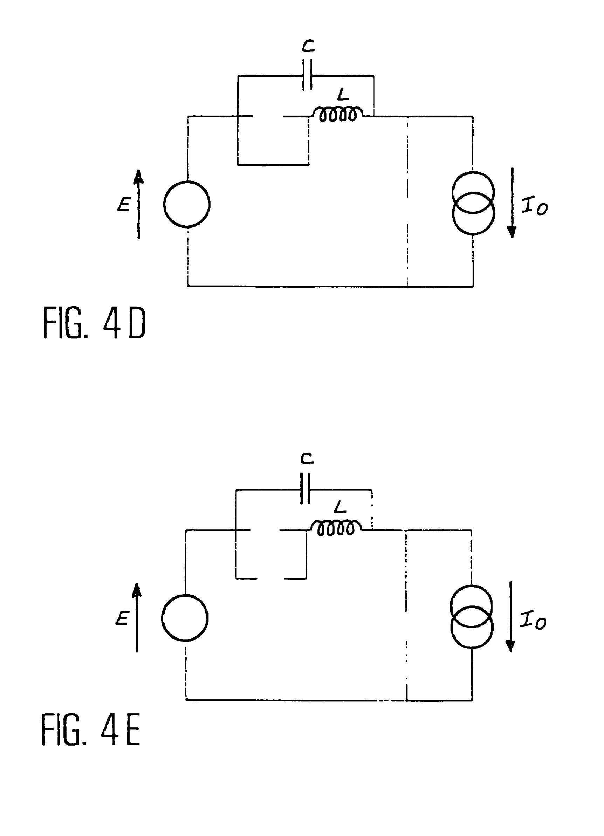

Sur la figure 4D, on a représenté la quatrième phase de fonctionnement de l'interrupteur haute tension de l'invention. Au cours cette phase, la résonance dans la cellule se poursuit. La diode D conduit ; un ordre de blocage est envoyé à l'interrupteur K' qui ne conduit alors pas de courant. Cette phase est équivalente à la deuxième phase de fonctionnement, c'est-à-dire celle représentée sur la figure 4B.

Sur la figure 4E, on a représenté la dernière phase de fonctionnement de l'interrupteur haute tension de l'invention. L'interrupteur K' est ouvert ; la diode D se bloque lorsque le courant dans l'inductance L s'annule. Le courant I₀ charge alors la capacité de résonance C. De ce fait, la tension aux bornes de la diode de roue libre Dᵣ₁ décroît. Lorsque la tension aux bornes de la capacité de résonance C atteint la valeur de la tension d'entrée E, alors la tension aux bornes de la diode de roue libre s'annule. Cette diode de roue libre se met alors en conduction. Et le circuit se retrouve à l'état initial de la figure 4A.

Selon un mode de réalisation de l'invention, les inductances L de chacune des cellules 1a, ..., 1n sont couplées magnétiquement les unes avec les autres, ce qui permet d'équilibrer les tensions des cellules, grâce au couplage magnétique.

Le convertisseur DC/DC haute tension comportant l'interrupteur électronique haute tension qui vient d'être décrit a l'avantage d'avoir une durée de vie supérieure à celle des convertisseurs connus grâce aux composants utilisés pour réaliser l'interrupteur haute tension.

En outre, ces composants sont assemblés en série, ce qui permet, en cas de déficience de l'un des composants, de ne court-circuiter qu'une seule cellule quasi-résonante, ce qui assure la continuité de fonctionnement de l'interrupteur haute tension.

De plus, la puissance dans le circuit est traitée par une haute tension, ce qui permet de gérer des courants réduits. Une réalisation sur circuit imprimé est alors possible, ce qui facilite la réalisation d'un convertisseur DC/DC haute tension et permet de réduire ses coûts par rapport à une structure fort courant classique qui nécessite généralement un montage mécanique onéreux.

Par ailleurs; l'obtention de fréquences de découpage élevées, c'est-à-dire supérieures à 10 kHz, permet de réduire la valeur du filtre capacitif de sortie, tout en maintenant un filtrage efficace.

Cet interrupteur haute tension présente, en outre, l'avantage que les capacités parasites avec l'environnement sont incluses dans les capacités des différents étages de l'interrupteur. Ainsi, les courants parasites, présents dans les solutions de l'art antérieur, sont fortement réduits dans l'interrupteur de l'invention et l'énergie contenue dans ces capacités parasites est recyclée dans l'énergie de résonance.

## Revendications

1. Interrupteur électronique haute tension traversé par un courant principal, **caractérisé en ce qu'**il comporte au moins deux cellules quasi-résonantes, 1a,..., 1n) connectées en série et comprenant chacune:
- au moins un condensateur de résonance (C);
- au moins un moyen écrêteur (Mₑ);
- au moins une inductance (L);
- au moins une diode (D) ;
- au moins un moyen d'interruption (K'), connecté de façon antiparallèle sur la diode (D) et constituant un moyen d'interruption bidirectionnel en courant et unidirectionnel en tension dans la cellule, ce moyen d'interruption étant tel que :
• sa fermeture provoque une décharge du condensateur de résonance dans l'inductance (L) de sorte que le courant principal traverse chaque cellule ;
• le courant dans l'inductance (L) s'inverse, provoquant la mise en conduction de la diode D); et
• son ouverture se fait naturellement lors de l'annulation du courant traversant alors l'inductance et la diode.

2. Interrupteur selon la revendication 1, **caractérisé en ce que**, dans chacune cellule de quasi-résonance, l'inductance est connectée en série avec le moyen d'interruption, lui-même associé de façon antiparallèle à la diode, cet ensemble inductance-diode-moyen d'interruption étant connecté en parallèle avec le condensateur de résonance, lui-même en parallèle avec le moyen écrêteur.

3. Interrupteur selon l'une quelconque des revendications 1 et 2, **caractérisé en ce que** l'inductance de chaque cellule est couplée magnétiquement avec les inductances des autres cellules.

4. Convertisseur DC/DC haute tension comportant une diode de roue libre (Dᵣ₁), une inductance (B) et au moins une capacité (A), **caractérisé en ce qu'**il comprote en outre un interrupteur électronique haute tension selon l'une quelconque des revendications 1 à 3.

## Claims

1. A high voltage electronic switch crossed by a main current, **characterized in that** it includes at least two quasi-resonant cells (la, ...1n) connected in series and each comprising:
- at least one resonance capacitor (C);
- at least one clipping means (Mₑ);
- at least one inductance (L);
- at least one diode (D);
- at least one switching means (K'), anti-parallel connected on the diode (D) and forming a bidirectional current and unidirectional voltage switching means in the cell, this switching means being such that:
• its closure causes discharge of the resonance capacitor into the inductance (L) so that the main current flows through each cell;
• the current in the inductance (L) is reversed, causing the diode (d) to become conductive; and
• its opening occurs naturally upon cancelling the current then flowing through the inductance and the diode.

2. The switch according to claim 1, **characterized in that**, in each quasi-resonance cell, the inductance is connected in series with the switching means, itself associated in anti-parallel with the diode, this inductance-diode-switching means assembly being connected in parallel with the resonance capacitor, itself in parallel with the clipping means.

3. The switch according to any of claims 1 and 2, **characterized in that** the inductance of each cell is magnetically coupled with the inductances of the other cells.

4. A high voltage DC/DC converter including a freewheel diode (Dᵣ₁), an inductance (B) and at least one capacitance (A), **characterized in that** it further includes a high voltage electronic switch according to any of claims 1 to 3.

## Patentansprüche

1. Von einem Hauptstrom durchflossener elektronischer Unterbrecherschalter für hohe Spannung, **dadurch gekennzeichnet, dass** er wenigstens zwei in Reihe geschaltete Quasiresonanz-Zellen (1a, ......., 1n) aufweist, deren jede jeweils umfaßt:
- wenigstens einen Resonanzkondensator ©;
- wenigstens ein Begrenzermittel (Mₑ);
- wenigstens eine Induktivität (L);
- wenigstens eine Diode (D) ;
- wenigstens ein Unterbrechermittel (K'), das in antiparalleler Anordnung über der Diode (D) liegt und ein bezüglich dem Strom bidirektionales und ein bezüglich der Spannung unidirektionales Unterbrechermittel in der Zelle darstellt, wobei dieses Unterbrechermittel so ausgebildet ist, dass:
- seine Schließung eine Entladung des Resonanzkondensators in die Induktivität (L) hervorruft, derart daß der Hauptstrom jeweils jede Zelle durchfließt;
- der Strom in der Induktivität (L) sich umkehrt, was den Übergang der Diode (D) in den leitenden Zustand bewirkt; und
- daß seine Öffnung von Natur aus erfolgt, sobald der dann die Induktivität und die Diode durchsetzende Strom Null wird.

2. Unterbrecherschalter nach Anspruch 1, **dadurch gekennzeichnet, dass** in jeder Quasiresonanz-Zelle die Induktivität jeweils in Reihe mit dem Unterbrechermittel liegt, das seinerseits antiparallel bezüglich der Diode angeordnet ist, wobei dieses Aggregat aus Induktivität-Diode-Unterbrechermittel parallel bezüglich dem Resonanzkondensator liegt, der seinerseits parallel zu dem Begrenzermittel liegt.

3. Unterbrecherschalter nach einem der Ansprüche 1 und 2, **dadurch gekennzeichnet, dass** die Induktivität jeder Zelle jeweils mit den Induktivitäten der anderen Zellen magnetisch gekoppelt ist.

4. DC/DC (Gleichstrom/Gleichstrom-) - Wandler für hohe Spannung, welcher eine freischwingende Diode (Freilaufdiode) (Dᵣ₁), eine Induktivität (B) und wenigstens eine Kapazität (A) aufweist, **dadurch gekennzeichnet, dass** er desweiteren einen elektronischen Unterbrecherschalter für hohe Spannung gemäß einem der Ansprüche 1 bis 3 umfasst.
